(19) **Europäisches Patentamt / European Patent Office / Office européen des brevets**

(11) **EP 3 171 514 A1**

(12) # EUROPEAN PATENT APPLICATION

(43) Date of publication:
**24.05.2017 Bulletin 2017/21**

(51) Int Cl.:
*H03F 1/32* (2006.01)  *H03F 3/45* (2006.01)
*H03K 5/24* (2006.01)

(21) Application number: **15195360.1**

(22) Date of filing: **19.11.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **NXP B.V.**
**5656 AG Eindhoven (NL)**

(72) Inventors:
  • **Bajoria, Shagun**
    **Redhill, Surrey RH1 1SH (GB)**
  • **Bolatkale, Muhammed**
    **Redhill, Surrey RH1 1SH (GB)**

  • **Rutten, Robert**
    **Redhill, Surrey RH1 1SH (GB)**
  • **Breems, Lucien**
    **Redhill, Surrey RH1 1SH (GB)**
  • **Brekelmans, Johannes**
    **Redhill, Surrey RH1 1SH (GB)**
  • **Niehof, Jan**
    **Redhill, Surrey RH1 1SH (GB)**

(74) Representative: **Terblanche, Candice Jane**
    **NXP SEMICONDUCTORS**
    **Intellectual Property Group**
    **Abbey House**
    **25 Clarendon Road**
    **Redhill, Surrey RH1 1QZ (GB)**

(54) **DIFFERENTIAL SUMMING NODE**

(57)    A summing node (200) is provided for summing a first (Vin+, Vin-) and second (Veld+,Veld-) differential signals. Each of the first and second differential signals comprise respective direct (Vin+, Veld+) and inverse (Vin-, Veld-) signal components. The summing node (200) comprises a first differential transistor pair (M1, M2) comprising a first (201a) and second (202a) input and coupled to a first (330) and second (340) output. The summing node (200) further comprises a second differential transistor pair (M3, M4) comprising a third (202b) and fourth (201b) input and coupled to the first (330) and second (340) output. The first (201a) and fourth (201b) inputs are respectively coupled to the direct (Vin+) and inverse (Vin-) signal components of the first differential signal and the second (202a) and third (202b) inputs are respectively coupled to the direct (Veld+) and inverse (Veld-) signal components of the second differential signal.

Figure 3

**Description**

**Field**

The present disclosure relates to a summing node in a delta-sigma modulator in particular, but not exclusively, for use in an analog to digital converter.

**Background**

Delta-sigma modulators can be considered to be a suitable architecture for medium bandwidth analog-to-digital converters (ADC) due to their tendencies toward linearity and power efficiency. However, the delta-sigma modulator is often clocked at high sampling rates which may introduce instability into the delta-sigma loop.
Implementations that address loop instability are of interest.

**Summary**

According to a first aspect, there is provided a summing node for summing a first and second differential signal, each comprising a direct and an inverse signal component; the summing node comprising: a first differential transistor pair comprising a first and second input and coupled to a first and second output; and a second differential transistor pair comprising a third and fourth input and coupled to the first and second output; wherein the first and fourth inputs are respectively coupled to the direct and inverse signal components of the first differential signal and the second and third inputs are respectively coupled to the direct and inverse signal components of the second differential signal.
The first output may be configured to output a signal corresponding to the sum of the direct signal component of the first differential signal and the inverse signal component of the second differential signal. The second output may be configured to output signal corresponding to a sum of the direct signal component of the second differential signal and the inverse signal component of the first differential signal. The summing node may further comprise a first load coupled to the first output and a second load coupled to the second output. The first and second transistor pairs may be matched. The first and second loads may be matched. The first and second differential transistor pairs may have proportional biasing. The second output may be the compliment of the first output. The first and second output may be coupled to a non-linear element. The non-linear element may be a quantizer.
According to a second aspect, there is provided a delta-sigma modulator comprising a summing node in accordance with the first aspect, wherein the first differential signal is output from a loop filter of the delta-sigma modulator and the second differential signal is an excess loop delay feedback signal from the output of the delta-sigma modulator.
According to a third aspect, there is provided a method comprising summing a first and second differential signal, each of the first and second differential signals comprising a direct and an inverse signal component; the summing comprising: providing the respective direct signal components as inputs to a first differential transistor pair coupled to a first and second output; and providing the respective indirect signal components as inputs to a second differential transistor pair coupled to the first and second output.
The method may further comprise: providing a signal corresponding to the sum of the direct signal component of the first differential signal and the inverse signal component of the second differential signal at the first output. The method may further comprise: providing a signal corresponding to a sum of the direct signal component of the second differential signal and the inverse signal component of the first differential signal at the second output. A first load may be coupled to the first output and a second load may be coupled to the second output.

**Brief Description of Drawings**

Figure 1 shows an example schematic of a delta-sigma modulator;

Figure 2 shows an example schematic of a summing node;

Figure 3 shows an example circuit diagram of a summing node; and

Figure 4 shows an example of an excess loop delay feedback loop.

**Description**

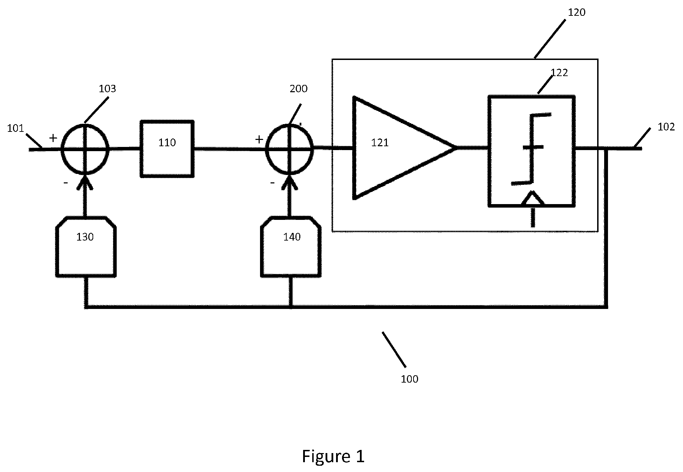

Figure 1 is an example of a delta-sigma modulator 100 that may be implemented in, for example, an analog-to-digital converter (ADC). It will be appreciated that delta-sigma modulators may be used in both analog-to-digital (ADC) and digital-to-analog converters (DAC).

Figure 1 comprises an input 101 for receiving an analog input signal and an output 102 for providing a digital output bit stream. The analog input signal 101 is input into a non-inverting input (+) of a summing node 103. The digital output bit stream 102 is input to a digital-to-analog converter (DAC) 130 in a feedback loop to the inverting input (-) of the summing node 103. Thus, the output of the DAC 130 is coupled to the inverting input (-) of the summing node 103.

An output of the summing node 103 is input to a loop filter 110. The output of the loop filter 110 is input to the non-inverting input (+) of an excess loop delay (ELD) summing node 200. The inverting input (-) of the ELD summing node 200 is coupled to the output of an ELD digital-to-analog converter (DAC) 140. The input of the ELD DAC 140 is coupled to the output bit stream 102 and forms an excess loop delay feedback from the output bit stream 102 to the ELD summing node 200.

An output of the ELD summing node 200 is input to the quantizer 120. The quantizer 120 comprises an amplifier 121 and a comparator 122. An input of the amplifier 121 is coupled to the output of the ELD summing node 200 and the output of the amplifier 121 is coupled to an input of the comparator 122. An output of the comparator 122 provides the output bit stream 102.

The delta-sigma modulator 100 may form part of an analog-to-digital converter. In this case the output bit stream 102 would be de-multiplexed and subsequently digitally low-pass filtered in order to provide a digital bit stream.

The output bit stream 102 may be a one bit stream comprising high and low values, the average of which represents the analog input signal. The bit stream 102 may be feedback through the DAC 130 and subtracted from the analog input signal 101 to determine whether the analog input signal is increasing or decreasing with respect to its previous value. The loop filter 110 may act as an integrator to integrate this difference which is then quantized. If, for example, the input signal 101 is increasing with respect to its previous value, the quantizer 120 will output a high value (a logical 1) in order to increase the average of the bit stream 102. If the input signal 101 is decreasing with respect to its average value, the quantizer 122 may output a low (logical 0) to decrease the average of the bit stream 102.

While some conventional ADC's may require a sample rate of more than twice the highest input signal frequency, delta-sigma modulators require a much higher sampling rate in order to produce a sufficient number of bit stream pulses on the output bit stream 102 to provide a better approximation of the input signal 101 by the averaging the output bit stream 102. Due to this high sampling rate, loop stability may become a serious issue. This loop stability may be affected, at least in part, by a delay introduced by the quantizer 120. In order to address loop stability, an excess loop delay (ELD) path may be implemented, for example the path provided by the ELD DAC 140 and ELD summing node 200 in figure 1.

Examples of the present disclosure are directed to implementing a differential signal summing node that may be suitable for applications where the summing speed of the node may be of interest. In some examples, the summing node may be used to provide the summing node 200 of figure 1, however it will be appreciated that the summing node may be implemented to sum any two differential signals. In particular, the summing node may be used to sum two differential signals where the output is provided to a non-linear entity such as, for example, a quantizer.

In examples, the summing node may be provided by two differential amplifiers where the first differential amplifier receives, as inputs, direct signals of a first and second differential signal pair and the second amplifier receives, as inputs, the inverse signals of the first and second differential signal pairs. The direct signals output from the respective amplifier pairs may be summed to provide a direct output and the inverse signals output from the respective amplifier pairs may be summed to provide an inverse output. The inverse output of the summing node may be the compliment of the direct output.

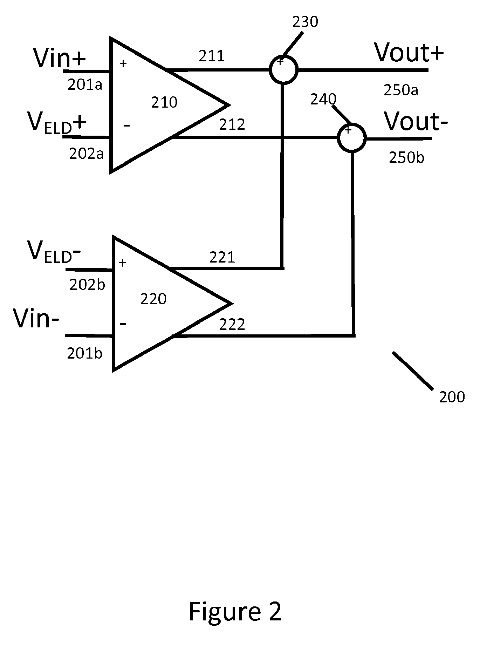

Figure 2 shows an example of a summing node 200 in accordance with examples. While the summing node 200 has been exemplified as being implemented in a delta-sigma modulator as an ELD summing node, it will be appreciated that the summing node 200 may be implemented in other applications where the summing speed of two differential input signals is of interest. The output of the summing node 200 may be provided to a non-linear element.

Figure 2 shows a summing node 200 comprising a first differential amplifier having a first (non-inverting) and second (inverting) input and a second differential amplifier 220 having a third (non-inverting) and fourth (inverting) input. The summing node 200 is configured to receive a first differential signal 201 ($V_{in}$) comprising a direct signal ($V_{in+}$) 201 a and an inverse signal ($V_{in-}$) 201 b. The direct signal 201 a is coupled or provided to the first (non-inverting) input of the first differential amplifier 210. The inverse signal 201 b is coupled or provided to a fourth (inverting) input of the second differential amplifier 220.

The summing node 200 is further configured to receive a second differential signal ($V_{ELD}$) comprising a direct signal ($V_{ELD}+$) 202a and an inverse signal ($V_{ELD}-$) 202b. The direct signal 202a is coupled or provided to the second (inverting) input of the first differential amplifier 210 and the inverse signal 202b is coupled or provided to the third (non-inverting) input of the second differential amplifier 220.

The first differential amplifier 210 comprises a first output 211 and a second output 212 and the second differential amplifier 220 comprises a third output 221 and a fourth output 222. The first output 211 and the third output 221 are summed at adder 230 to provide a direct signal 250a of a differential output signal pair 250 (Vout). The second output 212 and the fourth output 222 are summed at adder 240 to provide an inverse signal 250b of the differential output signal pair 250. It will be appreciated that the inverse output signal 250b may be the compliment of the direct output signal 250a.

In operation, the first differential amplifier 210 will output a differential output 211 and 212 corresponding to the difference between the direct signal components 201 a and 202a of the first and second differential input signal pairs ($V_{in+}$ and $V_{ELD}+$). The second differential amplifier 220 will output a differential output 221 and 222 corresponding to the difference between the inverse components 201 b and 202b of the first and second differential input signal pairs ($V_{in-}$ and $V_{ELD}-$). The direct signal components 211 and 221 of the output of the differential amplifiers and the inverse signal components 212 and 222 of the output of the differential amplifiers are summed respectively to provide a direct output signal component 250a and an inverse output signal component 250b that is the compliment to the direct output signal component 250a.

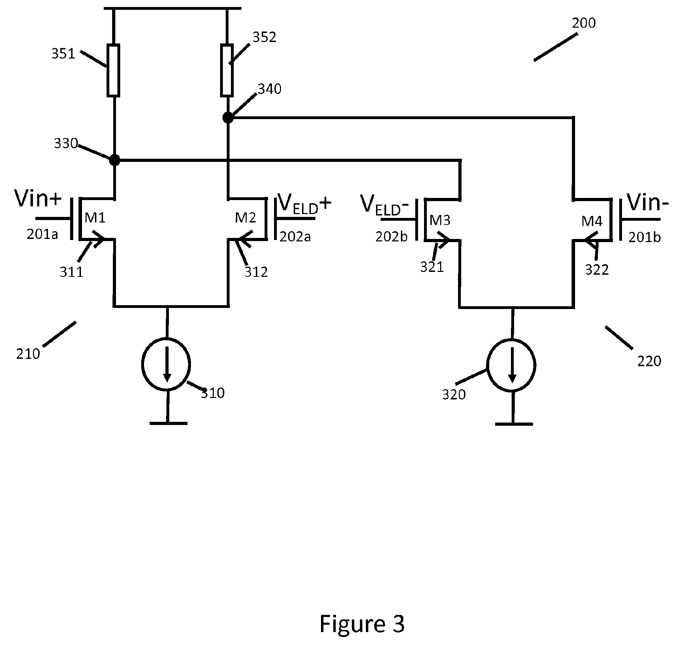

In figure 1, the summing node 200 and the amplifier 121 has been depicted as separate entities. However, it will be appreciated that the summing node 200 of figure 2 may carry out both the function of a summing node and the function of amplifier 121. In particular, the amplifiers 210, 220 may provide an amplified differential output. In the example with reference to figure 3, this amplification is provided by the $g_m$ of the transistors used to implement the differential amplifiers 210 and 220.

Figure 3 is an example implementation of summing node 200 using differential transistor pairs to provide the first and second differential amplifier 210 and 220 of figure 2. It will be appreciated that figure 3 shows a specific example implementation using n-channel metal oxide field effect semiconductor transistors (MOSFETS) however it will be appreciated that other types of transistors may be used to implement the differential amplifier pairs.

Figure 3 shows a first differential transistor pair 210 comprising a first transistor 311 (M1) and a second transistor 312 (M2). A gate terminal or input of the first transistor 311 is coupled to the direct signal component 201 a of the first differential input signal 201. A gate terminal or input of the second transistor 312 is coupled to the direct signal component 202a of the second differential input signal 202. Respective source terminals of the first and second transistors 311 and 312 are coupled to a bias current source 310. The summing node 200 further comprises a first and second load 351 and 352. It will be appreciated that the first and second load 351 and 352 may be any suitable load, for example they may be resistors or current sources. Drain terminals of the first and second transistors 311 and 312 are coupled to first terminals of the respective loads 351 and 352.

Figure 3 further shows a second differential transistor pair 220 comprising a third transistor 321 (M3) and a fourth transistor 322 (M4). A gate terminal or input of the third transistor 321 is coupled to the inverse signal component 202b of the second differential input signal 202. A gate terminal input of the fourth transistor 322 is coupled to the inverse signal component 201 b of the first differential input signal 201. Respective source terminals of the third and fourth transistors 321 and 322 are coupled to a current source 320. Drain terminals of the third and fourth transistors 321 and 322 are coupled to the first terminals of the respective loads 351 and 352.

The coupling point of the first terminal of the first load 351 and the drain terminals of the first transistor 311 and the third transistor 321 forms a first node 330. The coupling point of the first terminal of the second load 351 and the drain terminals of the second transistor 312 and the fourth transistor 322 forms a second node 340. The direct signal component 250a of the differential output signal 250 may be output from the first node 330 and the inverse signal component 250b of the differential output signal 250 may be output from the second node 340.

The differential transistor pairs 210 and 220 may be as symmetrical as possible. For example the differential transistor pairs may be matched. For example, the first to fourth transistors 311, 312, 321 and 322 may be selected to be as similar to each other as possible in transistor characteristics. The biasing of the first and second transistor pairs may be proportional. The first and second loads 351 and 352 may have the same value and the current sources may have a fixed relationship. For example, the current source 320 may be a multiple of the current source 310. This multiplication factor may be set by system level simulations.

For each transistor pair 210, 220, the gate inputs of the pair of transistors determines the proportion of the current provided by the current source 310, 320 that may be provided to the respective load 351, 352 through that transistor. For example, for the first transistor pair 210, the input 201 a to the first transistor 311 and the input 202a to the second transistor control the functioning of the first and second transistors 311 and 312 to proportionally split the current (provided by current source 310) that each of the transistors can pull through their respective loads 351, 352. Similarly, the inputs 202b and 201 b to the third and fourth transistors 321 and 322 control the proportion of the current (provided by current source 320) that can be pulled through the respective loads.

The value at the first node 330 may thus correspond to the proportion of the current 310 pulled through the first transistor 311 plus the proportion of the current 320 pulled through the third transistor 321. In other words, the output at the first node may correspond and/or be proportional to the sum of the direct signal of the first differential signal $V_{in+}$ 201 a and the indirect signal of the second differential signal $V_{eld-}$ 202b. Similarly the value at the second node 340 may thus correspond to the proportion of the current 310 pulled through the second transistor 312 plus the proportion of the current 320 pulled through the fourth transistor 322. In other words, the output at the second node may correspond and/or be proportional to the sum of the direct signal of the second differential signal $V_{eld+}$ 202a and the indirect signal of the first differential signal $Vin_{-}$ 201b.

It will be appreciated that difference between the output of the first node 330 and the output of the second node 340 may correspond to the difference between the first differential signal 201 and the second differential signal 202.

Referring to the example of figure 3, the common mode input voltage of the transistors can be considered to be $V_{cm}$.

We can write:

$$V_{in+} = V_{cm} + \Delta V_{in}/2 \qquad (1)$$

$$V_{in-} = V_{cm} - \Delta V_{in}/2 \qquad (2)$$

where, $\Delta V_{in}$ is the first differential input signal 201, $V_{in+}$ 201a is the direct signal component of the first differential input signal 201, $V_{in-}$ 201b is the inverse signal component of the first differential input signal 201, and $V_{cm}$ is the input common mode voltage.

Also,

$$V_{eld+} = V_{cm} + \Delta V_{eld}/2 \qquad (3)$$

$$V_{eld-} = V_{cm} - \Delta V_{eld}/2 \qquad (4)$$

where, $\Delta V_{eld}$ is the second differential input signal 202, $V_{eld+}$ 202a is the direct signal component of the second differential input signal 202, $V_{eld-}$ 202b is the inverse signal component of the second differential input signal 202, and $V_{cm}$ is the input common mode voltage.

Examples of the present disclosure may implement a summing node using two differential transistor pairs where the first differential transistor pair is configured to receive the direct signal components from the first and second differential input signals and the second differential transistor pair is configured to receive the inverse signal components of the first and second differential input signal.

The arrangement of the inputs to the first and second differential transistor pairs may lead to the summing node having a higher linearity at a higher speed (sampling rate) than some other summing nodes. This will be discussed below.

In contrast, in some delta-sigma modulators, a summing node may comprise a first differential transistor pair (M1 and M2) having the direct and inverse signal components of a first differential input signal as inputs and a second differential transistor pair (M3 and M4) having the direct and inverse signal components of a second differential input signal as inputs. For the case of these contrasting delta-sigma modulators, the following can be written:

The differential voltage signal present at inputs of the first differential transistor pair ($M_1/M_2$) is:

$$V_{in+} - V_{in-} = \Delta V_{in} \qquad (5)$$

Where $V_{in+}$ is the input to the first transistor M1 and $V_{in-}$ is the input to the second transistor M2 and the differential voltage signal at the inputs of the first transistor pair is $\Delta V_{in}$.

The differential voltage signal present at inputs of the second differential transistor pair ($M_3/M_4$) is:

$$V_{eld+} - V_{eld-} = \Delta V_{eld} \qquad (6)$$

Where $V_{eld+}$ is the input to the fourth transistor M4 and $V_{eld-}$ is the input to the third transistor M3 and the differential voltage signal at the inputs of the second transistor pair is $\Delta V_{eld}$.

The differential voltage signal $\Delta V_{in}$ at the input to the first transistor pair can be converted to a differential input current by multiplying it with the effective transconductance of the transistors M1 and M2 of the first transistor pair. The differential voltage signal $\Delta V_{eld}$ at the input to the second transistor pair can be converted to a differential input current by multiplying it with the effective transconductance of the transistors M3 and M4 of the second transistor pair.

If the system is assumed to be perfectly matched, the transconductance of the transistors M1 and M2, M3 and M4 are equal to $g_m$ and the following holds:

$$I_{M1/M2\_differential} = g_m * \Delta V_{in} \qquad (7)$$

$$I_{M3/M4\_differential} = g_m * \Delta V_{eld} \qquad (8)$$

Where $I_{M1/M2\_differential}$ is the differential current through the first transistor pair due to the differential voltage $\Delta V_{in}$ at the inputs of M1 and M2 and $I_{M3/M4\_differential}$ is the differential current through the second transistor pair due to the differential voltage $\Delta V_{eld}$ at the inputs of M3 and M4.

Considering an example case of equations 7 and 8 for a summing node that has a first differential signal as input into a first transistor pair and a second differential as input into a second differential pair, if the magnitude of the signals $\Delta V_{in}$ and $\Delta V_{eld}$ are in the range of 100mV and 50mV respectively, this may make the transconductance '$g_m$' nonlinear thus introducing the nonlinearity in current summation.

Referring to the example of the present disclosure and in particular the example of figure 3 following from equations 1 to 4, the differential voltage signal present at inputs of the first differential transistor pair 210 (equation 9) and the second differential transistor pair 220 (equation 10):

$$V_{in+} - V_{eld+} = (\Delta V_{in} - \Delta V_{eld})/2 \qquad (9)$$

$$V_{eld-} - V_{in-} = (\Delta V_{in} - \Delta V_{eld})/2 \qquad (10)$$

Where $\Delta V_{in}$ is the first differential input signal 201 and $\Delta V_{eld}$ is the second differential input signal 202 and the common mode input voltage $V_{cm}$ cancels out.

The transistor pairs 311 and 312, and 321 and 322 are matched and so the transconductance of each pair is $g_m$. The differential current through each pair 210 and 220 can be calculated by multiplying the differential voltages in 9 and 10 with the transconductance:

$$I_{M1/M2\_differential} = g_m * (\Delta V_{in} - \Delta V_{eld})/2 \qquad (11)$$

$$I_{M3/M4\_differential} = g_m * (\Delta V_{in} - \Delta V_{eld})/2 \qquad (12)$$

Where $I_{M1/M2\_differential}$ is the differential current through the first differential transistor pair 210 and $I_{M3/M4\_differential}$ is the differential current through the second differential transistor pair 220. If the magnitude of the signals $\Delta V_{in}$ and $\Delta V_{eld}$ are in the range of 100mV and 50mV respectively, then $(\Delta V_{in} - \Delta V_{eld})/2 = 25mV$. Thus the transconductance in equations 11 and 12 is multiplied by a lower factor than the transconductance in equations 7 and 8. The differential voltage signal present at inputs of the first differential transistor pair 210 and the second differential transistor pair 220 is less than if the inputs of the first differential transistor pair was coupling to the first differential input signal and the inputs of the second differential transistor pair were coupled to the second differential input signal. Linearity of the summing node 200 may be achieved around the input common mode.

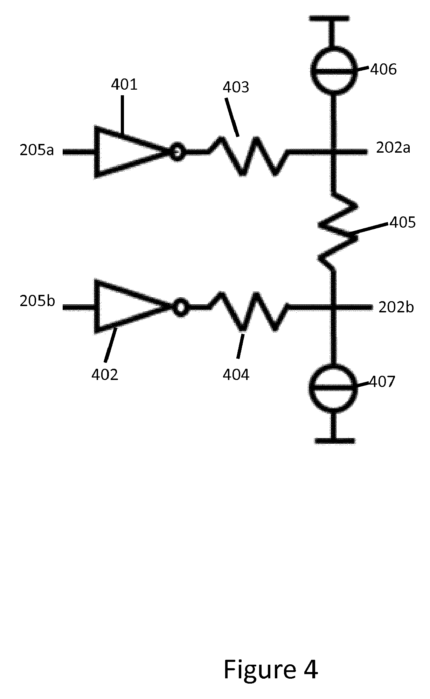

It will be appreciated that the summing node 200 of the foregoing examples may be used in any application where differential input signals are to be subtracted and the result provided to a non-linear element such as a quantizer. As discussed, a specific implementation of such a summing node 200 may be of use in a delta-sigma modulator, such as the one discussed in relation to figure 1. In particular, the summing node 200 may provide a summing node for an excess loop delay (ELD) feedback from the output 102 of the delta-sigma modulator to the input of the quantizer 120. Figure 4 shows an example of the generation of the ELD differential signal (second differential signal 202) that may be input into the summing node 200.

Figure 4 shows a differential output signal 205 from the quantizer 120. This signal 205 may correspond to signal 102 shown in figure 1. A direct signal component 205a of the differential output signal 205 is coupled to a first inverter 401. The output of the first inverter 401 is coupled to a first terminal of a first resistor 403. A second terminal of the first resistor 403 is coupled to provide the direct signal component 202a of the second differential signal 202a. An inverse signal component 205b is coupled to the input of a second inverter 402. An output of the second inverter 402 is coupled to a first terminal of a second resistor 404. A second terminal of the second resistor 404 is coupled to provide the inverse signal component 202b of the second differential signal. A first terminal of a third resistor 405 is coupled to the second terminal of the first resistor 403. A second terminal of the third resistor 405 is coupled to the second terminal of the second resistor 404. The second terminal of the first resistor 403 is coupled to a first signal source 406. The second terminal of the second resistor 404 is coupled to a second signal source 407.

The first and second signal sources 406 and 407 may be arranged so that the second signal source 407 is the inverse or compliment of the first signal source 406. The first and second signal sources 406 and 407 may be configured to introduce dither into the direct and inverse signal components 202a and 202b of the second differential input signal 202. The dither may be added to randomise third order tones due to square wave output from 122 at expense of increased noise in the wanted band.

It will be appreciated that while figure 1 depicts a first order delta-sigma modulator, examples may be applicable to higher order modulators.

While examples of the present disclosure have been described in relation to delta-sigma modulation, it will be appreciated that examples are applicable to the summation of other pairs of differential signal, in particular examples may be applicable to the summing of differential signals at the input of a non-linear element, for example a quantizer.

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the invention is, therefore, indicated by the appended claims rather than by this detailed description. All changes that come within the meaning and range of equivalency of the claims are to be embraced within their scope.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to an example or embodiment, or similar language means that a particular feature, structure, or characteristic described in connection with the indicated embodiment is included in at least one embodiment. Thus, the phrases "in one example" "in an example" and similar language throughout this specification may, but do not necessarily, all refer to the same embodiment.

## Claims

1. A summing node for summing a first and second differential signal, each comprising a direct and an inverse signal component; the summing node comprising:

   a first differential transistor pair comprising a first and second input and coupled to a first and second output; and
   a second differential transistor pair comprising a third and fourth input and coupled to the first and second output;
   wherein the first and fourth inputs are respectively coupled to the direct and inverse signals components of the first differential signal and the second and third inputs are respectively coupled to the direct and inverse signals components of the second differential signal.

2. The summing node of claim 1 wherein the first output is configured to output a signal corresponding to the sum of the direct signal component of the first differential signal and the inverse signal component of the second differential signal.

3. The summing node of any preceding claim wherein the second output is configured to output a signal corresponding to a sum of the direct signal component of the second differential signal and the inverse signal component of the first differential signal.

4. The summing node of any preceding claim comprising a first load coupled to the first output and a second load coupled to the second output.

5. The summing node of any preceding claim wherein the first and second transistor pairs are matched.

6. The summing node of claim 5 when dependent on claim 4 wherein the first and second load are matched.

7. The summing node of claim 5 wherein the first and second differential transistor pair have proportional biasing.

8. The summing node of any preceding claim where the second output is the compliment of the first output

9. The summing node of any preceding claim wherein the first and second output are coupled to a non-linear element.

10. The summing node of claim 9 wherein the non-linear element is a quantizer.

11. A delta-sigma modulator comprising a summing node in accordance with any of the claims 1 to 10, wherein the first differential signal is output from a loop filter of the delta-sigma modulator and the second differential signal is an excess loop delay feedback signal from the output of the delta-sigma modulator.

12. A method comprising summing a first and second differential signal, each of the first and second differential signals comprising a direct and an inverse signal component; the summing comprising:

   providing the respective direct signal components as inputs to a first differential transistor pair coupled to a first and second output; and
   providing the respective indirect signal components as inputs to a second differential transistor pair coupled to the first and second output.

13. The method of claim 12 further comprising:

   providing a signal corresponding to the sum of the direct signal component of the first differential signal and the inverse signal component of the second differential signal at the first output.

14. The method of any of claims 12 and 13 further comprising:

   providing a signal corresponding to a sum of the direct signal component of the second differential signal and the inverse signal component of the first differential signal at the second output.

15. The method of any of claims 12 to 14 wherein a first load is coupled to the first output and a second load is coupled to the second output.

Figure 1

Figure 2

Figure 3

Figure 4

Europäisches
Patentamt

European
Patent Office

Office européen
des brevets

# EUROPEAN SEARCH REPORT

Application Number

EP 15 19 5360

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 375 559 B1 (CHO THOMAS [US] ET AL) 20 May 2008 (2008-05-20) * col.2, 1.35-59, col.6, 1.6 - col.7, 1.3; figures 1,2,4,5 * | 1-8, 11-15 | INV. H03F1/32 H03F3/45 H03K5/24 |
| X | VIPUL KATYAL ET AL: "A New High Precision Low Offset Dynamic Comparator for High Resolution High Speed ADCs", CIRCUITS AND SYSTEMS, 2006. APCCAS 2006. IEEE ASIA PACIFIC CONFERENCE ON, IEEE, PISCATAWAY, NJ, USA, 1 December 2006 (2006-12-01), pages 5-8, XP031070760, ISBN: 978-1-4244-0387-5 * p.6, left-hand column, 1.11-49, right-hand column, 1.3-17; figure 2 * | 1-15 | |
| X | ZHANG BO ET AL: "A 40 nm CMOS 195 mW/55 mW Dual-Path Receiver AFE for Multi-Standard 8.5-11.5 Gb/s Serial L", IEEE JOURNAL OF SOLID-STATE CIRCUITS, IEEE SERVICE CENTER, PISCATAWAY, NJ, USA, vol. 50, no. 2, 1 February 2015 (2015-02-01), pages 426-439, XP011571315, ISSN: 0018-9200, DOI: 10.1109/JSSC.2014.2364032 [retrieved on 2015-01-28] * figure 14 * | 1-15 | TECHNICAL FIELDS SEARCHED (IPC) H03F H03K G06G |

The present search report has been drawn up for all claims

| Place of search | Date of completion of the search | Examiner |
|---|---|---|
| The Hague | 30 May 2016 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 19 5360

This annex lists the patent family members relating to the patent documents cited in  the above-mentioned European search report.
The members are as contained in the European Patent Office EDP file on
The European Patent Office is in no way liable for these particulars which are merely given for the purpose of information.

30-05-2016

| Patent document cited in search report | | Publication date | Patent family member(s) | | Publication date |
|---|---|---|---|---|---|
| US 7375559 | B1 | 20-05-2008 | US | 7375559 B1 | 20-05-2008 |
| | | | US | 7626426 B1 | 01-12-2009 |

EPO FORM P0459

For more details about this annex : see Official Journal of the European Patent Office, No. 12/82